# EUROPEAN PATENT APPLICATION

(11) **EP 1 134 797 A2**
(43) Date of publication of application: **19.09.2001**
(21) Application number: 01104417.9
(22) Date of filing: 26.02.2001
(51) Int. Cl.: H01L 21/331, H01L 29/732

(54) **Bipolar transistor having recessed and rounded surface and its manufacturing method**

(30) Priority: 14.03.2000 JP 2000071181
(71) Applicant: NEC CORPORATION, Tokyo (JP)
(72) Inventor: Sato, Akira, Yamagata-shi, Yamagata (JP)
(74) Representative: VOSSIUS & PARTNER

(57) **Abstract**

A bipolar transistor is constructed by a semiconductor substrate (1) having a recessed and rounded surface (Y), a collector region formed in the semiconductor substrate, a base region (8) formed in the semiconductor substrate in contact with the collector region and having a configuration along the recessed and rounded surface, an emitter region (13) formed between the recessed and round surface and the base region, and a graft base region (12) formed in the semiconductor substrate in contact with the base region at an outer portion of the recessed and rounded surface.

## Description

The present invention relates to a bipolar transistor and its manufacturing method.

In a prior art method for manufacturing a bipolar transistor, a first insulating layer, a first polycrystalline silicon layer of a second conductivity type and a second insulating layer are sequentially formed on a semiconductor substrate of a first conductivity type. Then, the second insulating layer and the first polycrystalline silicon layer are patterned to form an opening therein. Then, the first insulating layer is overetched by using the second insulating layer and the first polycrystalline silicon layer as a mask. Then, a second polycrystalline silicon layer is formed on the entire surface. Then, an oxidizing process is performed upon the second polycrystalline silicon layer except for a part of the second polycrystalline silicon layer under the first polycrystalline silicon layer, and the oxidized part of the second polycrystalline silicon layer is removed by a wet etching process. Then, impurities of the second conductivity type are implanted into the semiconductor substrate to form a base region. Then, a sidewall insulating layer is formed on a sidewall of the first and second polycrystalline silicon layers. Then, a third polycrystalline silicon layer of the first conductivity type is formed on the base region. Finally, an annealing operation is carried out. As a result, impurities of the second conductivity type are diffused from the first polycrystalline silicon layer via the second polycrystalline silicon layer into the semiconductor substrate to form a graft base region, and impurities of the first conductivity type are diffused from the third polycrystalline silicon layer into the base region to form an emitter region. Thus, since the semiconductor substrate is hardly etched at the wet etching process for etching the second polycrystalline silicon layer, the transistor characteristics are hardly deteriorated (see JP-A-11-283991 & U.S.Patent No. 6124181). This will be explained later in detail.

In the above-described prior art method, since the base region is formed by implanting impurities into the semiconductor substrate whose surface is flat, the base region is sharply edged. As a result, a base-to-collector current is focused on the edged portions, so that the base-to-collector breakdown voltage is mainly dependent upon the current flowing through the edged portions, to decrease the base-to-collector breakdown voltage. Particularly, when the bipolar transistor is more-fined, the base-to-collector breakdown voltage is remarkably decreased.

It is an object of the present invention to provide a bipolar transistor and its manufacturing method capable of improving the base-to-collector breakdown voltage characteristics.

According to the present invention, a bipolar transistor is constructed by a semiconductor substrate having a recessed and rounded surface, a collector region formed in the semiconductor substrate, a base region formed in the semiconductor substrate in contact with the collector region and having a configuration along the recessed and rounded surface, an emitter region formed between the recessed and round surface and the base region, and a graft base region formed in the semiconductor substrate in contact with the base region at an outer portion of the recessed and rounded surface.

Also, in a method for manufacturing a bipolar transistor, a first insulating layer, a first conductive layer of a second conductivity type and a second insulating layer are sequentially formed on a semiconductor substrate of a first conductivity type. Then, the second insulating layer and the first conductive layer are patterned by an anistropic etching process to form an opening in the second insulating layer and the first conductive layer. Then, the first insulating layer is overetched by using the second insulating layer and the first conductive layer. Then, a second conductive layer is formed on an entire exposed surface of the semiconductor substrate, the first and second insulating layers and the first conductive layer. Then, an isotropic microwave plasma etching process is performed upon the second conductive layer and the semiconductor substrate so that the second conductive layer is left only on sidewalls of the first insulating layer and an exposed surface of the semiconductor substrate is recessed and rounded. Then, impurities of the second conductivity type are implanted into the semiconductor substrate to form a base region in the semiconductor substrate. Then, a third insulating layer is formed on sidewalls of the second insulating layer and the first and second conductive layers. Then, a third conductive layer of the first conductivity type is formed on the base region in contact with the third insulating layer. Finally, an annealing operation is carried out. As a result, impurities of the second conductivity type are diffused from the first conductive layer via the second conductive layer into the semiconductor substrate to form a graft base region in the semiconductor substrate in contact with the base region, and impurities of the first conductivity type are diffused from the third conductive layer into the base region to form an emitter region in the base region.

The present invention will be more clearly understood from the description set forth below, as compared with the prior art, with reference to the accompanying drawings, wherein:
Figs. 1A through 1M are cross-sectional views for explaining a prior art method for manufacturing a bipolar transistor;
Figs. 2A through 2H are cross-sectional views for explaining an embodiment of the method for manufacturing a bipolar transistor according to the present invention;
Fig. 3 is a graph showing a relationship between the insertion gain and the depth of the recessed and rounded portion of Fig. 2H;
Fig. 4 is a graph showing the base-to-collector breakdown voltage characteristics of the present invention and the prior art;
Fig. 5 is a plan view illustrating a buried collector type bipolar transistor to which the embodiment of the present invention is applied; and
Figs. 6 and 7 are cross-sectional views taken along the lines VI-VI and VII-VII, respectively, of Fig. 5.

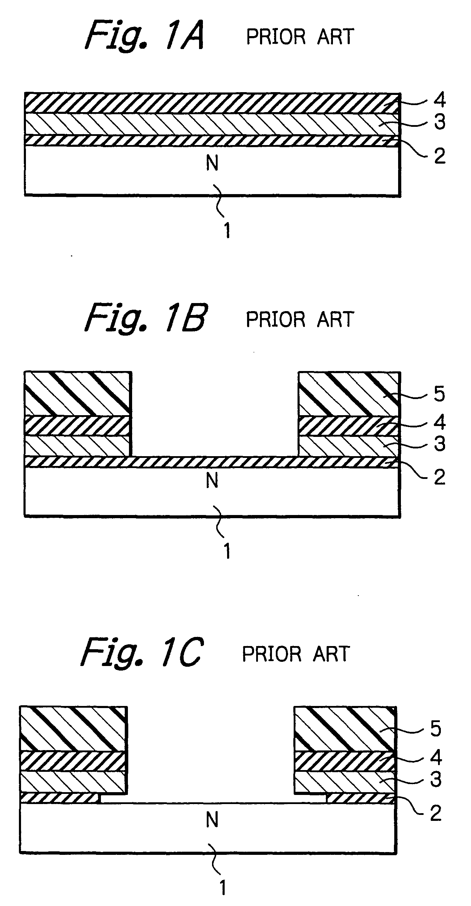

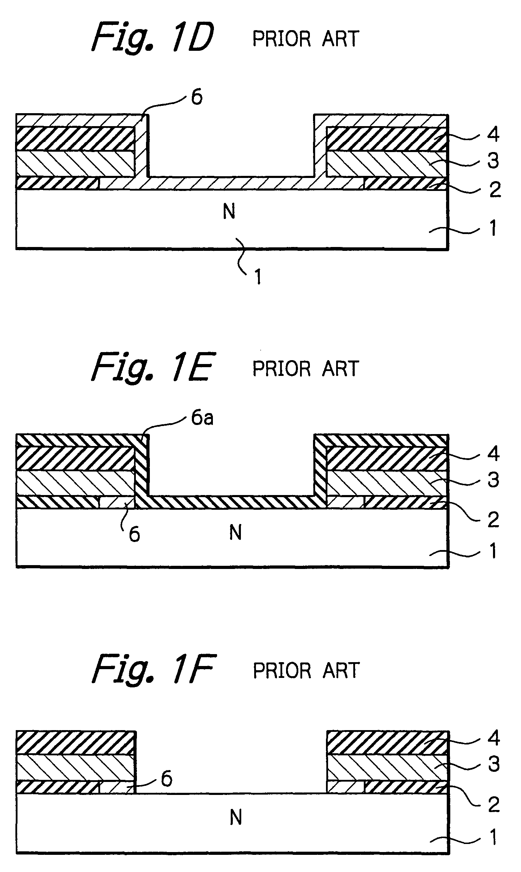

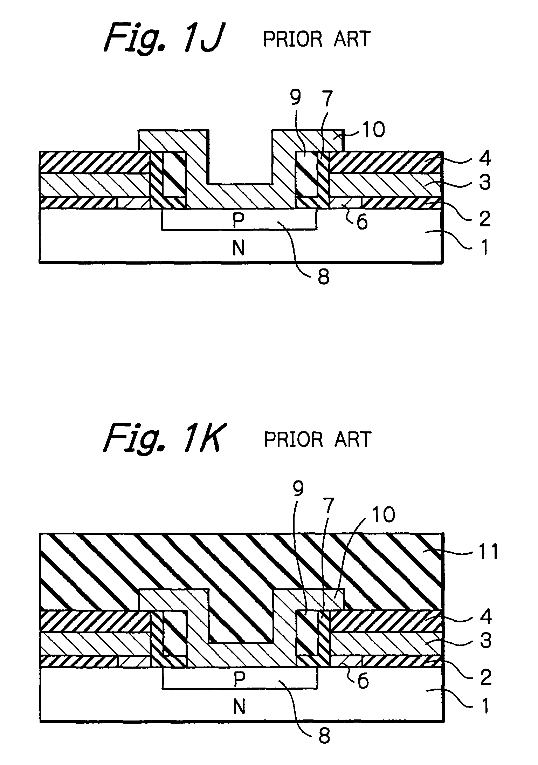

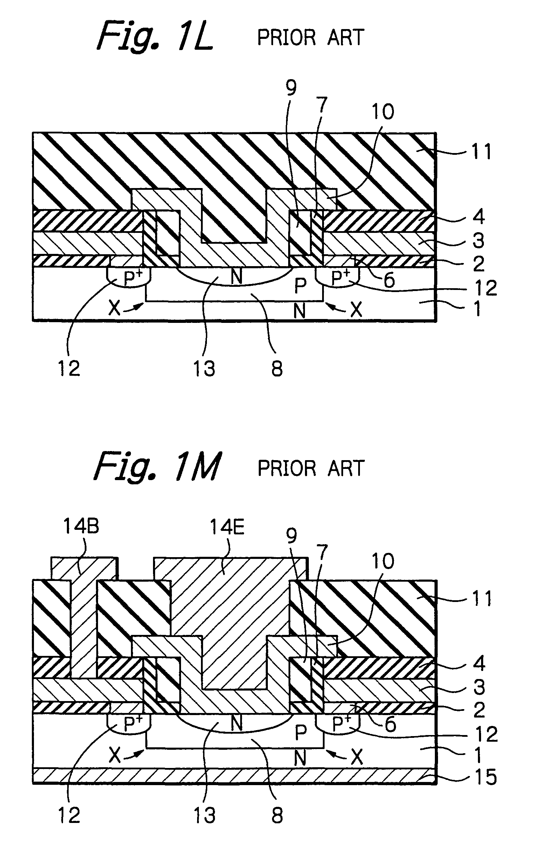

Before the description of the preferred embodiment, a prior art method for manufacturing a bipolar transistor will be explained with reference to Figs. 1A through 1M (see JP-A-11-283991 & U.S.Patent No.6,124,181).

First, referring to Fig. 1A, an oxidation process is performed upon an N-type monocrystalline silicon substrate 1 to form a silicon oxide layer 2. Then, a boron-doped polycrystalline silicon layer 3 is deposited on the silicon oxide layer 2 by a chemical vapor deposition (CVD) process. Then, a silicon nitride layer 4 is deposited on the boron-doped polycrystalline silicon layer 3 by a CVD process.

Next, referring to Fig. 1B, a photoresist pattern layer 5 is formed on the silicon nitride layer 4 by a photolithography process. Then, the silicon nitride layer 4 and the boron-doped polycrystalline silicon layer 3 are etched by an anistopic dry etching process using the photoresist pattern layer 5 as a mask. Then, an opening is perforated in the silicon nitride layer 4 and the boron-doped polycrystalline silicon layer 3.

Next, referring to Fig. 1C, the silicon oxide layer 2 is side-etched by an isotropic ethcing process, i.e., a wet etching process using the photoresist pattern layer 5, the silicon nitride layer 4 and the boron-doped polycrystalline silicon layer 3 as a mask. Then, the photoresist pattern layer 5 is removed.

Note that the photoresist pattern layer 5 can be removed before the side-etching of the silicon oxide layer 2.

Next, referring to Fig. 1D, a non-doped polycrystalline silicon layer 6 is deposited on the entire surface by a CVD process.

Next, referring to Fig. 1E, an oxidation process is performed upon the non-doped polycrystalline silicon layer 6. As a result, an exposed portion of the non-doped polycrystalline silicon layer 6 is converted into a silicon oxide layer 6a.

Next, referring to Fig. IF, the silicon oxide layer 6a is etched by a wet etching process using hydrogen fluoride and using the silicon nitride layer 4 as a mask. As a result, the non-doped polycrystalline silicon layer 6 is left only on the sidewalls of the silicon oxide layer 6, so that the boron-doped polycrystalline silicon layer 3 is connected via the non-doped polycrystalline silicon layer 6 to the monocrystalline silicon substrate. In this case, note that the monocrystalline silicon substrate 1 is hardly etched, so that the surface thereof is flat.

In Figs. 1E and IF, although the non-doped polycrystalline silicon layer 6 is oxidized, an anisotropic plasma etching process can be performed directly upon the non-doped polycrystalline silicon layer 6, so that the non-doped polycrystalline silicon layer 6 is left only on the sidewalls of the silicon oxide layer 6. Even in this case, the surface of the monocrystalline silicon substrate 1 is flat.

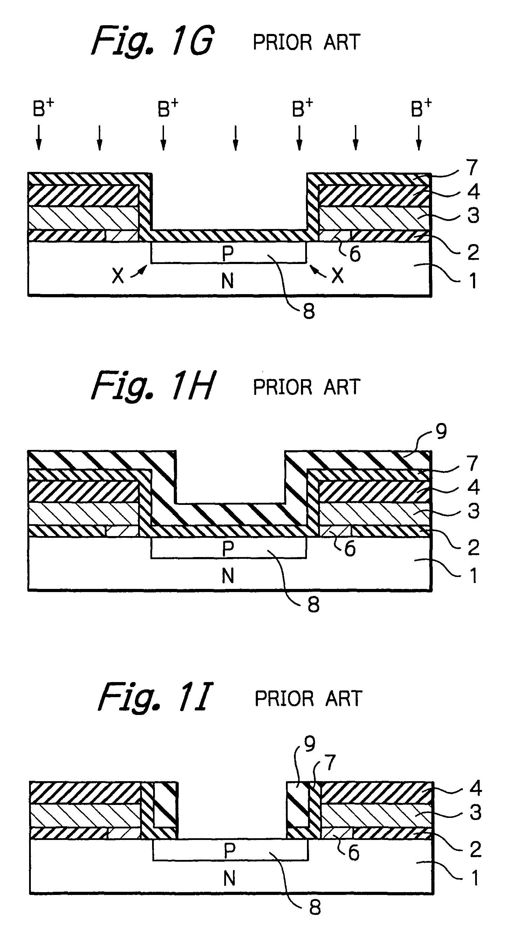

Next, referring to Fig. 1G, a silicon oxide layer 7 is deposited on the entire surface by a CVD process. Then, boron ions are implanted into the monocrystalline silicon substrate 1 by using the silicon nitride layer 4 and the boron-doped polycrystalline silicon layer 3 as a mask. As a result, a P-type base layer 8 is formed within the monocrystalline silicon substrate 1. In this case, the P-type base layer 8 is edged as indicated by arrows X.

Next, referring to Fig. 1H, a silicon nitride layer 9 is deposited on the entire surface by a CVD process.

Next, referring to Fig. 1I, the silicon nitride layer 9 is etched back by an anisotropic dry etching process, and then, the silicon oxide layer 7 is etched by a wet etching process. Thus, a sidewall insulating layer serving as an isolation region between a base lead-out portion and an emitter lead-out portion is formed by the silicon oxide layer 7 and the silicon nitride layer 9.

Next, referring to Fig. 1J, an arsenic-doped polycrystalline silicon layer 10 is deposited on the entire surface by a CVD process. Then, the arsenic-doped polycrystalline silicon layer is patterned by a photolithography and etching process.

Next, referring to Fig. 1K, an insulating layer 11 made of phospho-silicated glass (PSG) or the like is deposited on the entire surface by a CVD process.

Next, referring to Fig. 1L, an annealing operation is carried out. As a result, boron ions are diffused from the boron-doped polycrystalline silicon layer 3 via the non-doped polycrystalline silicon layer 6 into the monocrystalline silicon substrate 1, to form a P⁺-type graft base region 12 within the monocrystalline silicon substrate. In this case, the P-type base region 8 per se is expanded by the annealing operation, so that the P-type base region 8 is in contact with the P⁺-type graft base region 12. Note that the edged portions X remain in the P-type base region 8. Simultaneously, arsenic ions are diffused from the arsenic-doped polycrystalline silicon layer 10 into the monocrystalline silicon substrate 1, to form an N-type emitter region 13 within the P-type base region 8.

Finally, referring to Fig. 1M, a contact hole is perforated in the insulating layer 11, and then, an emitter electrode 14E is formed therein. Also, a base electrode 14B is formed and connected to the P'-type graft base region 12. Further, a collector electrode 15 is formed on the back surface of the monocrystalline silicon substrate 1.

Thus, a vertical NPN-type bipolar transistor having the monocrystalline silicon substrate 1 as a collector connected to a collector electrode (not shown) is completed.

In the bipolar transistor manufactured by the method as illustrated in Figs. 1A through 1M, since the P-type base region 8 is formed by implanting boron ions into the monocrystalline silicon substrate 1 whose surface is flat, the P-type base region 8 is edged as indicated by arrows X in Fig. 1M. As a result, a base-to-collector current is focused on the edged portions X, so that the base-to-collector breakdown voltage is mainly dependent upon the current flowing through the edged portions X, to decrease the base-to-collector breakdown voltage. Particularly, when the bipolar transistor is more-fined, the base-to-collector breakdown voltage is remarkably decreased.

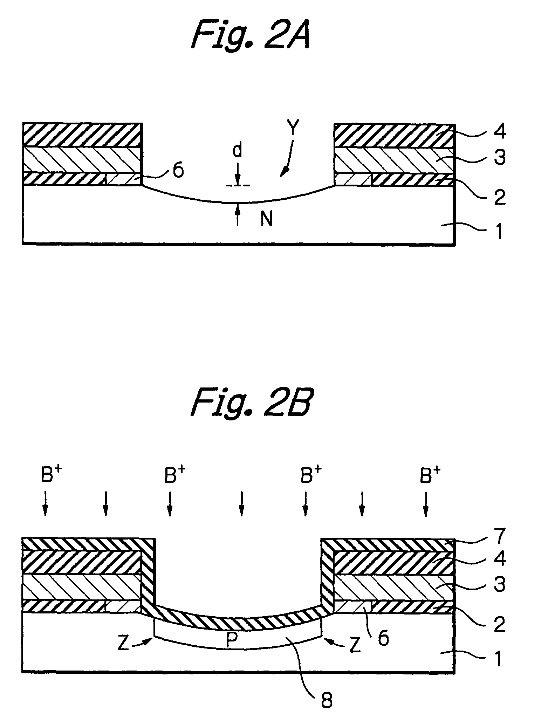

An embodiment of the method for manufacturing a bipolar transistor according to the present invention will be explained next with reference to Figs. 2A through 2H.

First, the manufacturing steps as illustrated in Figs. 1A through 1D are carried out. That is, an oxidation process is performed upon an N-type monocrystalline silicon substrate 1 to form a silicon oxide layer 2. Then, a boron-doped polycrystalline silicon layer 3 is deposited on the silicon oxide layer 2 by a CVD process. Then, a silicon nitride layer 4 is deposited on the boron-doped polycrystalline silicon layer 3 by a CVD process. Then, a photoresist pattern layer 5 is formed on the silicon nitride layer 4 by a photolithography process. Then, the silicon nitride layer 4 and the boron-doped polycrystalline silicon layer 3 are etched by an anisotropic dry etching process using the photoresist pattern layer 5 as a mask. Then, an opening is perforated in the silicon nitride layer 4 and the boron-doped polycrystalline silicon layer 3. Then, the silicon oxide layer 2 is side-etched by an isotropic etching process, i.e., a wet etching process using the photoresist pattern layer 5, the silicon nitride layer 4 and the boron-doped polycrystalline silicon layer 3 as a mask. Then, the photoresist pattern layer 5 is removed. Then, a non-doped polycrystalline silicon layer 6 is deposited on the entire surface by a CVD process.

Next, referring to Fig. 2A, an isotropic microwave plasma etching process is performed upon the non-doped polycrystalline silicon layer 6. As a result, the non-doped polycrystalline silicon layer 6 is left only on the sidewalls of the silicon oxide layer 6, so that the boron-doped polycrystalline silicon layer 3 is connected via the non-doped polycrystalline silicon layer 6 to the monocrystalline silicon substrate. Simultaneously, the monocrystalline silicon substrate 1 is also etched by the isotropic microwave plasma etching process, so that the surface of the monocrystalline silicon substrate 1 is recessed and rounded, as indicated by an arrow Y. In this case, the depth "d" of the recessed and rounded portion Y is about 1000 to 1500Å.

Next, referring to Fig. 2B, in the same way as in Fig. 1G, a silicon oxide layer 7 is deposited on the entire surface by a CVD process. Then, boron ions are implanted into the monocrystalline silicon substrate 1 by using the silicon nitride layer 4 and the boron-doped polycrystalline silicon layer 3 as a mask. As a result, a P-type base layer 8 is formed within the monocrystalline silicon substrate 1. Even in this case, the P-type base region 8 is edged as indicated by arrows Z. However, the sharpness of the edged portions Z are alleviated as compared with the edged portions X of Fig. 1G, due to the rounded surface of the monocrystalline silicon substrate 1.

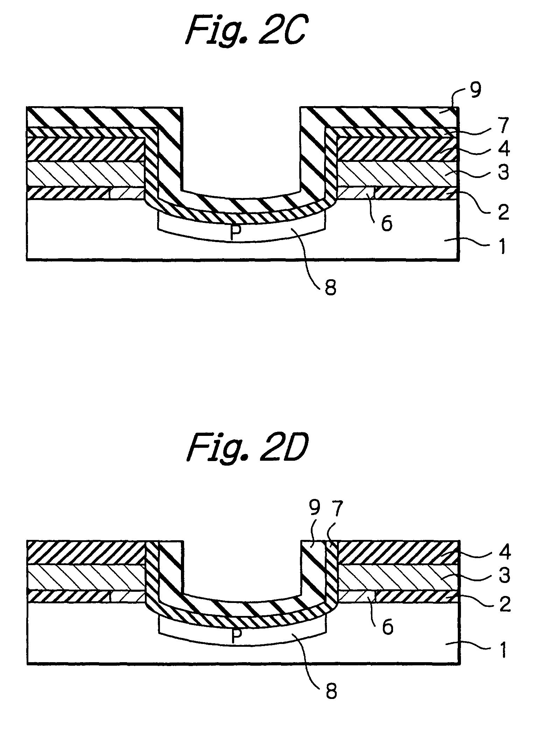

Next, referring to Fig. 2C, in the same way as in Fig. 1H, a silicon nitride layer 9 is deposited on the entire surface by a CVD process.

Next, referring to Fig. 2D, in the same way as in Fig. 1I, the silicon nitride layer 9 is etched back by an anisotropic dry etching process, and then, the silicon oxide layer 7 is etched by a wet etching process. Thus, a sidewall insulating layer serving as an isolation region between a base lead-out portion and an emitter lead-out portion is formed by the silicon oxide layer 7 and the silicon nitride layer 9.

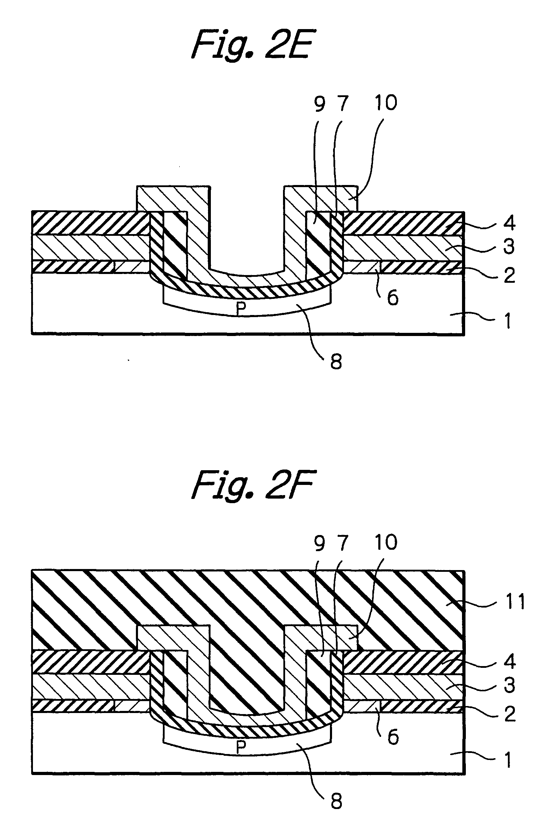

Next, referring to Fig. 2E, in the same way as in Fig. 1J, an arsenic-doped polycrystalline silicon layer 10 is deposited on the entire surface by a CVD process. Then, the arsenic-doped polycrystalline silicon layer is patterned by a photolithography and etching process.

Next, referring to Fig. 2F, in the same way as in Fig. 1K, an insulating layer 11 made of PSG or the like is deposited on the entire surface by a CVD process.

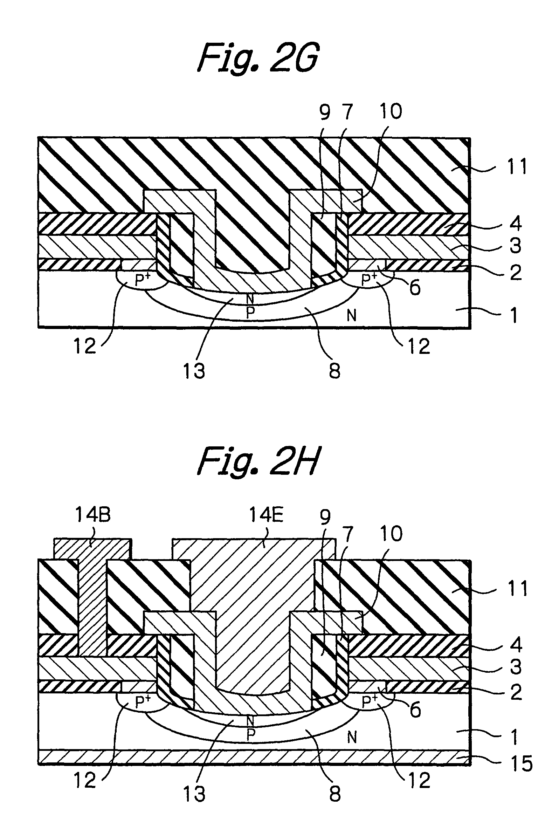

Next, referring to Fig. 2G, in the same way as in Fig. 1L, an annealing operation is carried out. As a result, boron ions are diffused from the boron-doped polycrystalline silicon layer 3 via the non-doped polycrystalline silicon layer 6 into the monocrystalline silicon substrate 1, to form a P⁺-type graft base region 12 within the monocrystalline silicon substrate 1. In this case, the P-type base region 8 per se is expanded by the annealing operation, so that the P-type base region 8 is in contact with the P⁺-type graft base region 12. Note that the edged portions Z of the P-type base region 8 are absorbed into the P⁺-type graft base region 12. Simultaneously, arsenic ions are diffused from the arsenic-doped polycrystalline silicon layer 10 into the monocrystalline silicon substrate 1, to form an N-type emitter region 13 within the P-type base region 8.

Finally, referring to Fig. 2H, in the same way as in Fig. 1M, a contact hole is perforated in the insulating layer 11, and then, an emitter electrode 14E is formed therein. Also, a base electrode 14B is formed and connected to the P⁺-type graft base region 12. Further, a collector electrode 15 is formed on the back surface of the monocrystalline silicon substrate 1.

Thus, a vertical NPN-type bipolar transistor having the monocrystalline silicon substrate 1 as a collector connected to a collector electrode (not shown) is completed.

In the bipolar transistor manufactured by the method as illustrated in Figs. 2A through 2H as well as Figs. 1A through 1D, since the P-type base region 8 is formed by implanting boron ions into the monocrystalline silicon substrate 1 whose surface is recessed and rounded, the P-type base region 8 is rounded as illustrated in Fig. 2H. As a result, a base-to-collector current is not focused on the portions near the P⁺-type graft base region 12, so that the base-to-collector current is made uniform within the P-type base region 8, to increase the base-to-collector breakdown voltage. Particularly, even when the bipolar transistor is more-fined, the base-to-collector breakdown voltage is not decreased.

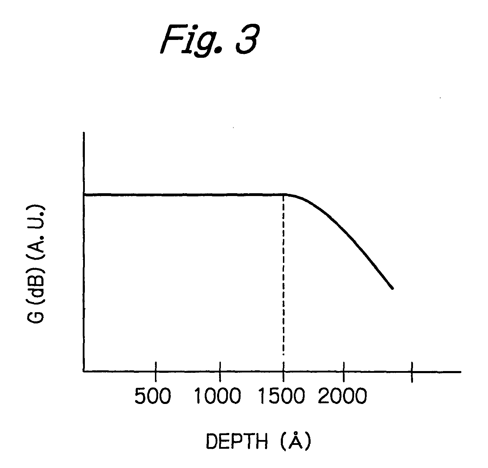

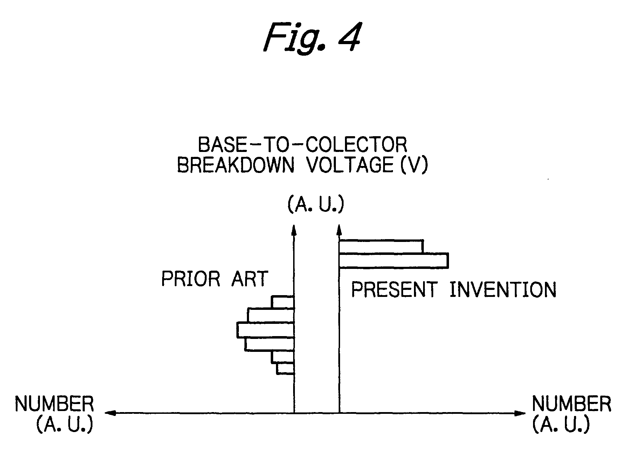

In Fig. 3, which shows a relationship between the insertion gain G and the depth "d" of the recessed and rounded portion Y of the monocrystalline silicon substrate 1 of Fig. 2A, when the depth "d" is less than about 1500Å, the insertion gain G is not decreased. On the other hand, when the depth "d" is more than about 1500Å, the length of the P-type base region 8 between the P⁺-type graft base regions 12 is substantially increased, so that the base resistance is increased, which would deteriorate the high frequency characteristics. Note that the larger the depth "d", the larger the base-to-collector breakdown voltage. For example, when the depth "d" is more than about 500Å, particularly, more than about 1000 Å, the base-to-collector breakdown voltage has been increased, as shown in Fig. 4.

In view of the foregoing, the depth "d" of the recessed and rounded portion Y of the monocrystalline silicon substrate 1 of Fig. 2A is about 500Å to 1500Å, preferably, about 1000Å to 1500Å.

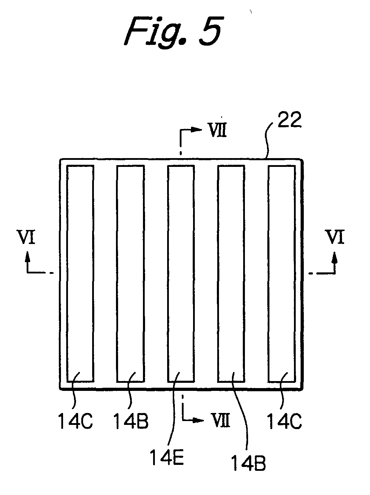

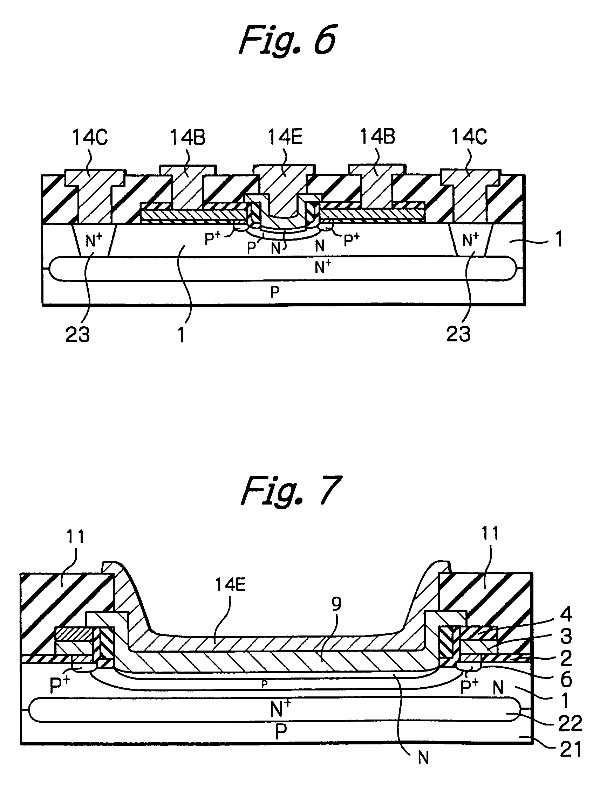

The about-described embodiment is applied to a buried collector type bipolar transistor as illustrated in Figs. 5, 6 and 7. Note that Fig. 5 is a plan view, and Figs. 6 and 7 are cross-sectional views taken along the lines VI - VI and VII-VII, respectively, of Fig. 5. In Figs. 5, 6 and 7, reference numeral 21 designates a P-type monocrystalline silicon substrate, 22 designates an N⁺-type buried collector region, and 23 designates an N⁺-type collector lead-out region. In this case, the N'-type buried collector region 22 and the N⁺-type collector lead-out region 23 as well as the N-type monocrystalline silicon substrate 1 can be formed by an epitaxial layer. Also, reference numerals 14B and 14C designate a base electrode and a collector electrode, respectively.

The above-described embodiment is related to a vertical NPN-type bipolar transistor; however, the present invention can be applied to a vertical PNP-type bipolar transistor. Also, the base region 8 can be formed by a vapor phase diffusion process, a solid phase diffusion process or an epitaxial growth process.

As explained hereinabove, according to the present, since the base region is rounded, the base-to-collector breakdown voltage characteristics can be improved.

## Claims

1. A bipolar transistor comprising:
a semiconductor substrate (1) having a recessed and rounded surface (Y);
a collector region formed in said semiconductor substrate;
a base region (8) formed in said semiconductor substrate in contact with said collector region, said base region having a configuration along said recessed and rounded surface;
an emitter region (13) formed between said recessed and round surface and said base region; and
a graft base region (12) formed in said semiconductor substrate in contact with said base region at an outer portion of said recessed and rounded surface.

2. The bipolar transistor as set forth in claim 1, further comprising a collector electrode (15) formed on a back surface of said semiconductor substrate.

3. The bipolar transistor as set forth in claim 1, further comprising a buried collector region (22) beneath said collector region.

4. The bipolar transistor as set forth in claim 1,2 or 3, wherein a depth of said semiconductor substrate at said recessed and rounded surface is about 1000Å to 1500Å.

5. The bipolar transistor as set forth in claim 1,2 or 3, wherein a depth of said semiconductor substrate at said recessed and rounded surface is about 500Å to 1500Å.

6. A method for manufacturing a bipolar transistor, comprising the steps of:
forming a first insulating layer (2) on a semiconductor substrate (1) of a first conductivity type;
forming a first conductive layer (3) of a second conductivity type on said first insulating layer;
forming a second insulating layer (4) on said first conductive layer;
patterning said second insulating layer and said first conductive layer by an anisotropic etching process to form an opening in said second insulating layer and said first conductive layer;
overetching said first insulating layer by using said second insulating layer and said first conductive layer, after said opening is formed;
forming a second conductive layer (6) on an entire exposed surface of said semiconductor substrate, said first and second insulating layers and said first conductive layer;
performing an isotropic microwave plasma etching process upon said second conductive layer and said semiconductor substrate so that said second conductive layer is left only on sidewalls of said first insulating layer and an exposed surface of said semiconductor substrate is recessed and rounded;
implanting impurities of said second conductivity type into said semiconductor substrate to form a base region (8) in said semiconductor substrate, after said isotropic microwave plasma etching process is performed;
forming a third insulating layer (9) on sidewalls of said second insulating layer and said first and second conductive layers, after said base region is formed;
forming a third conductive layer (9) of said first conductive type on said base region in contact with said third insulating layer; and
carrying out an annealing operation, so that impurities of said second conductivity type are diffused from said first conductive layer via said second conductive layer into said semiconductor substrate to form a graft base region (12) in said semiconductor substrate in contact with said base region and impurities of said first conductivity type are diffused from said third conductive layer into said base region to form an emitter region (13) in said base region.

7. The method as set forth in claim 6, wherein said second conductive layer is non-doped.

8. The method as set forth in claim 6 or 7, further comprising a step of forming a buried collector region (22) beneath said collector region.

9. The method as set forth in claim 6,7 or 8, wherein a depth of said semiconductor substrate at said recessed and rounded surface is about 1000Å to 1500Å.

10. The method as set forth in claim 6, 7 or 8, wherein a depth of said semiconductor substrate at said recessed and rounded surface is about 500Å to 1500Å.
